(19) Europäisches Patentamt
European Patent Office
Office européen des brevets

(11) **EP 3 913 378 A1**

(12) **EUROPEAN PATENT APPLICATION**

(43) Date of publication:
**24.11.2021 Bulletin 2021/47**

(51) Int Cl.:
**G01R 1/07** *(2006.01)*          **G01R 29/08** *(2006.01)*
**G01R 29/10** *(2006.01)*

(21) Application number: **21174679.7**

(22) Date of filing: **01.11.2019**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **01.11.2018   JP 2018206436**

(62) Document number(s) of the earlier application(s) in accordance with Art. 76 EPC:
**19878346.6 / 3 875 972**

(71) Applicants:
• **National University Corporation Tokai National Higher Education and Research System**
**Nagoya-shi, Aichi-ken 464-8601 (JP)**
• **Think-Lands Co., Ltd.**
**Yokohama-city, Kanagawa 230-0046 (JP)**

(72) Inventors:
• **HISATAKE, Shintaro**
**Gifu, 5011193 (JP)**
• **OIKAWA, Yoichi**
**Kanagawa, 230-0046 (JP)**
• **MIYAJI, Kunio**
**Kanagawa, 230-0046 (JP)**
• **TOJO, Makoto**
**Kanagawa, 230-0046 (JP)**

(74) Representative: **Plougmann Vingtoft a/s**
**Strandvejen 70**
**2900 Hellerup (DK)**

Remarks:
This application was filed on 19-05-2021 as a divisional application to the application mentioned under INID code 62.

(54) **ELECTROMAGNETIC WAVE MEASUREMENT PROBE**

(57)      [Summary]

[Problem] To provide an electromagnetic wave measurement probe that is able to measure the spatial distribution characteristics of an electromagnetic wave with a differential measurement.

[Solving Means] An electromagnetic wave measurement probe of the present invention includes a first measurement unit having a sensor structure that includes an electro-optic crystal that exhibits an electro-optic effect, an optical fiber that is provided on the root side of the electro-optic crystal and is configured to transmit an optical signal, and a reflection unit that is provided on the tip side of the electro-optic crystal and is configured to reflect the optical signal, and a second measurement unit having the sensor structure, and in first and second directions perpendicular to the axis direction of the optical fiber, the size of the electro-optic crystal is set to 1/2 or less of the wavelength of the measurement target electromagnetic wave, so that the electromagnetic wave may be measured with high accuracy.

[FIG. 5]

**Description**

Technical Field

The present invention is suitable for an electromagnetic wave measurement probe for measuring the spatial distribution characteristics of an electromagnetic wave, for example.

Background Art

With the recent spread of millimeter wave radars, there has been an increasing need of measuring the spatial distribution characteristics (amplitude and phase, intensity, frequency, and others in one dimension, two dimensions, and three dimensions) of an electromagnetic wave with high frequency, such as a millimeter wave, with high accuracy. To meet the need, there is known a method of measuring the spatial distribution characteristics of an electromagnetic wave using so-called electro-optic crystals that exhibit an electro-optic effect that is produced when light acts on a material influenced by an electromagnetic wave (see, for example, PTL1).

In addition, there has been proposed a method of measuring the spatial distribution characteristics of an electromagnetic wave with a differential measurement using two electro-optic crystals, without using a synchronization signal for the measurement target electromagnetic wave (see, for example, PTL2)

Citation List

Patent Literature

PTL 1: Japanese Laid-open Patent Publication No. 2001-343410
PTL 2: Japanese Laid-open Patent Publication No. 2017-15703

Summary of Invention

Technical Problem

To achieve the above-mentioned differential measurement, a measurement probe for measuring the spatial distribution characteristics of an electromagnetic wave is needed.

The present invention has been made in view of the above problem and intends to provide an electromagnetic wave measurement probe for measuring the spatial distribution characteristics of an electromagnetic wave with a differential measurement, an electromagnetic wave measurement system using the electromagnetic wave measurement probe, and bundled optical fibers.

Solution to Problem

To solve the above problem, a measurement probe of the present invention is a measurement probe that is used in an electromagnetic wave measurement system that measures a change in an optical signal caused by electro-optic effect according to a measurement target electromagnetic wave, using the measurement probe including a first measurement unit and a second measurement unit, and measures the spatial distribution characteristics of the measurement target electromagnetic wave, based on differential values detected while moving the measurement probe, the differential values representing changes in the optical signal. The measurement probe includes:

the first measurement unit having a sensor structure, the sensor structure including an electro-optic crystal that exhibits an electro-optic effect, an optical fiber that is provided on a root side of the electro-optic crystal and is configured to transmit the optical signal, and a reflection unit that is provided on a tip side of the electro-optic crystal and is configured to reflect the optical signal; and
the second measurement unit having the sensor structure,
wherein in first and second directions perpendicular to the axis direction of the optical fiber, a size of the electro-optic crystal is set to 1/2 or less of a wavelength of the measurement target electromagnetic wave.

Further, an electromagnetic wave measurement system of the present invention includes: a measurement probe including a first measurement unit having a sensor structure, the sensor structure including an electro-optic crystal that exhibits an electro-optic effect, an optical fiber that is provided on a root side of the electro-optic crystal and is configured to transmit an optical signal, and a reflection unit provided on a tip side of the electro-optic crystal, and a second measurement unit having the sensor structure, wherein a size of the electro-optic crystal is set to 1/2 or less of a wavelength of the measurement target electromagnetic wave in first and second directions perpendicular to an axis direction of the optical fiber,
a difference detection unit that detects a differential value representing a change in the optical signal caused by the electro-optic crystals between the first measurement unit and the second measurement unit, and
an electromagnetic wave characteristic computing unit that computes the spatial distribution characteristics of the electromagnetic wave, based on differential values detected while moving the measurement probe, the differential values representing changes in the optical signal.

Bundled optical fibers of the present invention include:

a plurality of fiber core members each including a core part that is configured to transmit an optical signal and a cladding part that covers the core part and has a different refractive index from the core part; and
a capillary that has a plurality of holes approximately identical in size to the plurality of fiber core members and fixes the plurality of fiber core members in a state where the plurality of fiber core members are inserted in the plurality of holes.

Advantageous Effects of Invention

The present invention provides an electromagnetic wave measurement probe for measuring the spatial distribution characteristics of an electromagnetic wave with a differential measurement, an electromagnetic wave measurement system using the electromagnetic wave measurement probe, and bundled optical fibers.

Brief Description of Drawings

[FIG. 1] FIG. 1 is a schematic diagram of an electromagnetic wave measurement system according to a first embodiment.
[FIG. 2] FIG. 2 is a schematic diagram illustrating the arrangement of an electromagnetic wave measurement device according to the first embodiment.
[FIG. 3] FIG. 3 is a block diagram illustrating the electromagnetic wave measurement device.
[FIG. 4] FIG. 4 is a schematic diagram illustrating an example of scanning at the time of measurement by the electromagnetic wave measurement device.
[FIG. 5] FIG. 5 is a schematic diagram for explaining the concepts (1) of a measurement probe.
[FIG. 6] FIG. 6 is a schematic diagram illustrating the concepts (2) of the measurement probe.
[FIG. 7] FIG. 7 is a schematic diagram for explaining a flow of light and an electrical signal in the electromagnetic wave measurement device according to the first embodiment.
[FIG. 8] FIG. 8 includes schematic diagrams illustrating the configuration (1) of the measurement probe according to the first embodiment.
[FIG. 9] FIG. 9 includes schematic diagrams illustrating the configuration (2) of the measurement probe according to the first embodiment.
[FIG. 10] FIG. 10 includes schematic diagrams illustrating the configuration of a measurement probe according to a second embodiment.
[FIG. 11] FIG. 11 is a schematic diagram for explaining a flow of light and an electrical signal in a electromagnetic wave measurement device according to the second embodiment.
[FIG. 12] FIG. 12 is a graph representing a comparison of resolution among different separation distances, obtained by simulation (E plane/ 300 GHz).
[FIG. 13] FIG. 13 is a graph representing a comparison of resolution among different separation distances, obtained by simulation (H plane/ 300 GHz).
[FIG. 14] FIG. 14 is a graph representing a comparison between simulated values and measured values (E plane/ 75.6 GHz/ crystal quantity of 4).
[FIG. 15] FIG. 15 is a graph representing a comparison between simulated values and measured values (H plane/ 75.6 GHz/ crystal quantity of 4).
[FIG. 16] FIG. 16 is a graph representing a comparison between simulated values and measured values (E plane/ 300 GHz/ crystal quantity of 1).
[FIG. 17] FIG. 17 is a graph representing a comparison between simulated values and measured values (H plane/ 300 GHz/ crystal quantity of 1).

Description of Embodiments

(First Embodiment)

Hereinafter, some embodiments will be described with reference to the accompanying drawings.

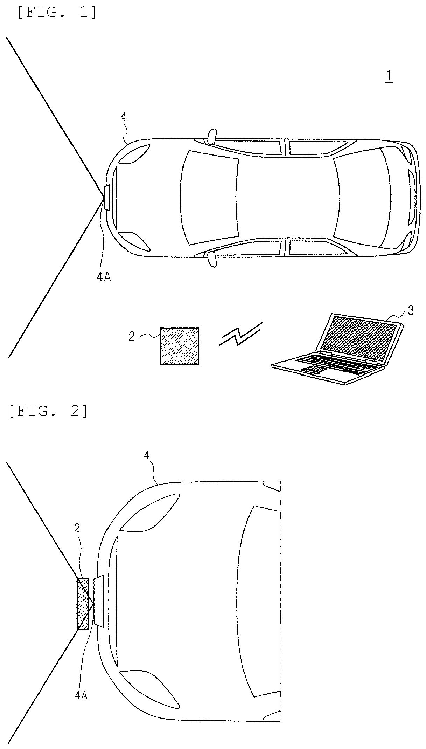

As illustrated in FIG. 1, reference numeral 1 denotes an electromagnetic wave measurement system as a whole, in which an electromagnetic wave measurement device 2 performs measurement and a computing device 3 performs aggregation. FIGS. 1 and 2 schematically illustrate a case of measuring an electromagnetic wave emitted by a radar 4A, which is a measurement target, mounted on an automobile 4. The electromagnetic wave measurement system 1 is an asynchronous electromagnetic wave measurement system that measures a measurement target electromagnetic wave, without receiving a reference signal from the radar 4A, that is, without performing signal synchronization with the measurement target directly.

The radar 4A, which is the measurement target, is an FMCW (frequency-modulated continuous wave) radar that uses a continuous wave that is generated by frequency-modulating a triangle wave. Therefore, the measurement target electromagnetic wave to be measured is an FMCW signal. In this connection, *f*(RF) does not refer to a function but represents a measurement frequency that is the frequency of a signal. Hereinafter, a signal name is indicated in parentheses. In the drawings, on the other hand, the signal name is indicated without using parentheses, like fRF simply.

As illustrated in FIG. 2, the electromagnetic wave measurement device 2 is disposed in the vicinity of the radar 4A and is configured to measure an electromagnetic wave and supply the measurement result to the computing device 3.

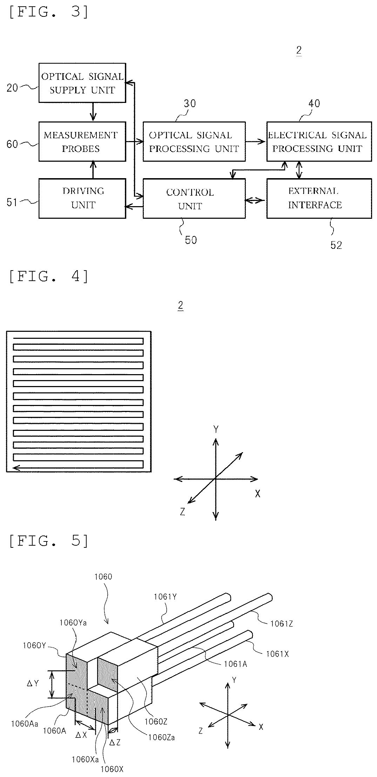

As illustrated in FIG. 3, in the electromagnetic wave measurement device 2, a control unit 50 made up of an MPU (micro processing unit), a ROM (read only memory), and a RAM (random access memory), which are not illustrated, controls the entire processing according to an electromagnetic wave measurement program stored in advance in the ROM. The electromagnetic wave measurement device 2 measures an electromagnetic wave in collaboration with the computing device 3 via an external interface 52.

The electromagnetic wave measurement device 2 performs the measurement by a driving unit 51 causing a measurement probe 60 to move. As illustrated in FIG. 4, the driving unit 51 moves in the X-Y direction within the housing of the box-shaped electromagnetic wave measurement device 2, which causes the measurement probe 60 projecting outward to scan the XY plane in zig-zag manner. Although not illustrated, the driving unit 51 may cause the measurement probe 60 to scan the YZ plane or XZ plane, or three-dimensionally.

The computing device 3 has a computer configuration, including a CPU (centralo processing unit), a ROM (read only memory), and a RAM (random access memory), which are not illustrated, and computes the spatial distribution characteristics (the distributions of amplitude, phase, intensity, frequency, and others in one dimension, two dimensions, and three dimensions) of an electromagnetic wave on the basis of data supplied from the electromagnetic wave measurement device 2 wirelessly or wired. Specifically, for example, the computing device 3 computes and visualizes spatial distributions such as the spatial amplitude distribution and the spatial phase distribution of the electromagnetic wave in the XY plane, the XZ plane, and the YZ plane, and specifies a region where the numerical values of the intensity, frequency, and others of the electromagnetic wave are unexpected values. By doing so, the electromagnetic wave measurement system 1 is able to diagnose the excitation distribution of the antenna of the radar 4A and to compute the far-field radiation patterns thereof.

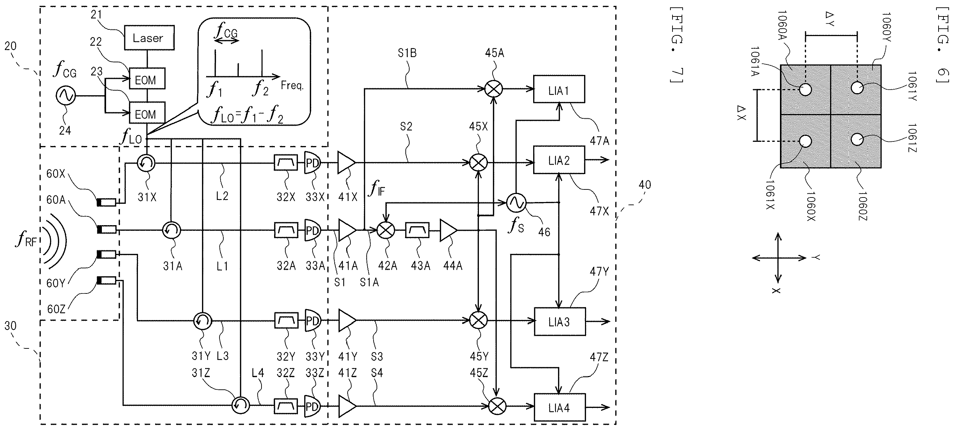

FIGS. 5 and 6 are conceptual diagrams for explaining a measurement probe 1060. The configuration of the measurement probe 60 used in the embodiment will be described in detail later. For convenience, each constitutional element illustrated in FIGS. 5 and 6 is designated by a reference numeral obtained by adding 1000 to the reference numeral of a corresponding constitutional element used in the embodiment. The measurement probe 1060 is made up of four EO (electro-optic) sensors 1060A, 1060X, 1060Y, and 1060Z that extend in parallel to the Z direction. The EO sensors 1060A, 1060X, 1060Y, and 1060Z are connected to four polarization maintaining fibers 1061A, 1061X, 1061Y, and 1061Z, respectively. Note that optical fibers such as single mode fibers may be used in place of the polarization maintaining fibers.

The EO sensors (1060A, 1060X, 1060Y, and 1060Z) are located at fixed positions with respect to each other. With the EO sensor 1060A as a basis, the EO sensor 1060X is fixed at a position separated by a separation distance $\Delta X$ in the X direction, the EO sensor 1060Y is fixed at a position separated by a separation distance $\Delta Y$ in the Y direction, and the EO sensor 1060Z is fixed at a position separated by the separation distance $\Delta X$ in the X direction, the separation distance $\Delta Y$ in the Y direction, and a separation distance $\Delta Z$ in the Z direction. In this connection, as illustrated in FIG. 6, the separation distances $\Delta X$ and $\Delta Y$ are each a distance between the centers of polarization maintaining fibers 61, and the separation distance $\Delta Z$ (see FIG. 5) is a distance between the tip end surfaces 1060Aa and 1060Za of the EO sensors 1060A and 1060Z.

A reflection mirror is provided on the tip end surface 1060a (1060Aa, 1060Xa, 1060Ya, 1060Za) of each electro-optic crystal forming an EO sensor. Therefore, an optical signal supplied to each EO sensor through a polarization maintaining fiber 61 is reflected at a reflection point on the tip end surface 1060a and re-enters the polarization maintaining fiber 61. At this time, the optical signal is modulated (changed) by electro-optic effect (a refractive index change of the electro-optic crystal) due to the influence of the measurement target electromagnetic wave of $f$(RF).

The EO sensors have the separation distances Δ (ΔX, ΔY, and ΔZ) therebetween, and the phase and amplitude of the measurement target electromagnetic wave are different according to the separation distances Δ. Therefore, the electromagnetic wave measurement system 1 computes differences between a signal obtained by the EO sensor 1060A and each signal obtained by the EO sensors 1060X, 1060Y, and 1060Z, to thereby obtain differential values (hereinafter, referred to as separation-distance-based differences) representing changes of the measurement target electromagnetic wave based on the separation distances Δ. Then, the electromagnetic wave measurement system 1 integrates the separation-distance-based differences to thereby compute the spatial distribution characteristics of the electromagnetic wave on the basis of the separation-distance-based differences.

FIG. 7 illustrates the configurations of an optical signal supply unit 20, the measurement probe 60, an optical signal processing unit 30, and an electrical signal processing unit 40 in the electromagnetic wave measurement device 2. The optical signal supply unit 20 is an optical frequency comb generator that is made up of a laser light source 21, EOMs (electro-optic modulators) 22 and 23, and a synthesizer 24, for example. The laser light source 21 is a LO (local oscillator) light source and is configured to emit an optical signal to the EOMs 22 and 23. The EOMs 22 and 23 modulate the received optical signal to a two-tone signal with two frequencies f(1) and f(2), with reference to a frequency interval signal f(CG) generated by the synthesizer 24. These two input optical signals are referred to as input optical signals E1 and E2. An input frequency $f$(LO) for the input optical signals E1 and E2 is expressed by the equations (1) and (2).

$$f(\mathrm{LO}) \;=\; f(1) \;-\; f(2) \;\ldots\; (1)$$

$$f(\mathrm{IF}) \;=\; |f(\mathrm{RF}) \;-\; f(\mathrm{LO})|,$$

where

$$f(\mathrm{LO}), \; f(\mathrm{RF}) \;\gg\; f(\mathrm{IF}) \;\ldots (2)$$

The differential frequency f(IF) is set to a frequency (for example, approximately 100 kHz to 10 MHz) that is manageable as an electrical signal. As described earlier, $f$(RF) is used for an FMCW signal, and the frequency changes along the time axis. The electromagnetic wave measurement system 1 exercises feedback control to adjust the frequencies f(1) and $f$(2) of the input optical signals E1 and E2 so that the differential frequency $f$(IF) maintains constant.

The input optical signals are each split into four waves, which are then supplied to the EO sensors 60A, 60X, 60Y, and 60Z in the measurement probe 60 via circulators 31 (31A, 31X, 31Y, and 31Z).

The EO sensors 60A, 60X, 60Y, and 60Z return the input optical signals E1 and E2 as measurement optical signals back to the corresponding polarization maintaining fibers 61 in a state where the signals are subjected to modulation due to the influence of the measurement target electromagnetic wave (measurement frequency $f$(RF)). The circulators 31 input the measurement optical signals to optical paths L1 to L4. Hereinafter, the optical path L1 will be described. The other optical paths L2 to L4 have the same configuration and operations, and the description thereof is omitted.

As described above, the input optical signals E1 and E2 have the paired frequencies $f$(1) and $f$(2). Each EO sensor 60A, 60X, 60Y, and 60Z generates modulation sidebands ES1 and ES2 arranged at intervals of measurement frequency $f$(RF) with the frequencies $f$(1) and $f$(2) as centers. Therefore, one of the modulation sidebands ES1, ES2 appears at the frequency shifted by the differential frequency $f$(IF) from the frequency $f$(2), $f$(1) of the input optical signal E2, E1 paired with the original input optical signal E1, E2. The optical filter 32 allows either the input optical signal E2 and modulation sidebands ES1 or the input optical signal E1 and modulation sidebands ES2 to pass therethrough and propagate to a photodiode 33A.

The photodiode 33A converts the input optical signal and modulation sidebands into an electrical signal as a beat signal of the differential frequency $f$(IF). As a result, the photodiode 33A outputs a measurement electrical signal of the differential frequency $f$(IF) to an electrical path S1 of the electrical signal processing unit 40.

The electrical signal processing unit 40 has the electrical path S1 in which a reference signal is generated from a measurement electrical signal and electrical paths S2 to S4 in which separation-distance-based differences are detected from the measurement electrical signal including the separation-distance-based differences. Lock-in amplifiers (LIA) 47X, 47Y, and 47Z in the electrical paths S2 to S4 obtain differences between the measurement electrical signal and the reference signal, thereby computing the separation-distance-based differences. The following describes the case where the reference signal is input to the electrical path S2. Since the electrical paths S3 and S4 have the same configuration and operations as the electrical path S2, and therefore the description thereof is omitted.

In the electrical path S1, the base signal of a base frequency $f(S)$ that is used as a reference for detection is mixed with the reference signal to thereby generate a reference mixed signal. Then, a mixer 45X on the electrical path S2 multiplies it and eliminates fluctuations in the differential frequency $f(IF)$ component and the measurement target electromagnetic wave, and then the lock-in amplifier 47X detects separation-distance-based differences in the X-direction. In this connection, a phase and an amplitude are detected as the separation-distance-based differences.

At this time, the lock-in amplifier 47X detects the separation-distance-based differences such that the frequency of the detection does not exceed 1/2 of the frequency of the measurement target electromagnetic wave in the relationship with the moving speed of the measurement probe 60 in the driving unit 51. This makes it possible to detect the influence of the measurement target electromagnetic wave accurately.

In the electrical path S1B, the reference mixed signal is input to the lock-in amplifier 47A, so that excess phase fluctuations added at the filter 43A when the differential frequency $f(IF)$ component fluctuates is detected. In this connection, the electrical path S1B is not always needed.

The following describes the configuration of the measurement probe 60.

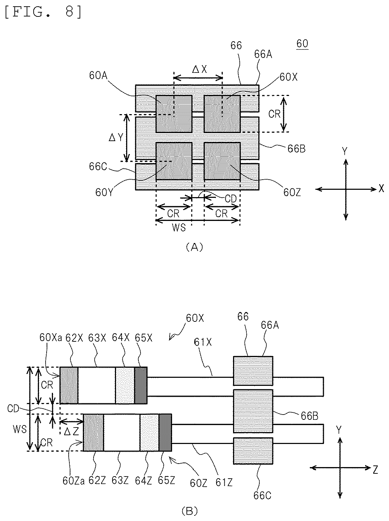

As illustrated in (A) of FIG. 8, the measurement probe 60 has a total of four EO sensors 60A, 60X, 60Y, and 60Z, two in the X direction and two in the Y direction, which are arranged in a grid with the separation distances $\Delta X$ and $\Delta Y$ therebetween in the XY plane. In addition, as illustrated in (B) of FIG. 8 representing the positional relationship between the EO sensors 60X and 60Z, only the EO sensor 60Z is arranged with its tip end separated from the tip ends of the EO sensors 60A, 60X and 60Y by the separation distance $\Delta Z$.

The EO sensors 60A, 60X, 60Y, and 60Z have the same configuration. The following describes the EO sensor 60X, and the description of the others is omitted.

The EO sensor 60X has a shape of cuboid as a whole that is long in the Z direction, and has optical elements arranged in a row. The optical elements each have a square bottom surface with each side being a crystal side CR. The polarization maintaining fiber 61X is connected to the root of the EO sensor 60X. Although there is no restriction on the crystal side CR and the diameter $\varphi$ of the polarization maintaining fiber 61, the crystal side CR is set to 1.0 mm and the diameter $\varphi$ is set to 0.5 mm, for example. The crystal side CR and the diameter $\varphi$ are appropriately determined on the basis of various conditions including the separation distances $\Delta X$, $\Delta Y$, and $\Delta Z$ and a manufacturing method. The EO sensor 60X is formed by arranging a reflection substrate 62X, an EO crystal 63X, a glass substrate 64X, and a collimator lens 65X in this order from the tip end side and fixing these together with an optical adhesive.

The EO crystal 63 is preferably a crystal with a natural birefringence. More specifically, the EO crystal 63 is an inorganic crystal with a natural birefringence, such as LiTaO3 (lithium tantalate), LiNbO3 (Lithium niobate), BaTaO3 (barium titanate), SBN (sodium barium niobate), or ZGP (Zinc phosphide germanium).

Alternatively, the EO crystal 63 is an organic nonlinear optical crystal with a natural birefringence, such as DAST (4-N,N-dimethylamino-4'-N'-methyl-stilbazolium tosylate), DASC (4-N,N-dimethylamino-4'-N'-methyl-stilbazolium p-chlorobenezenesulfonate, DSTMS (4-N,N-dimethylamino-4'-N'-methyl-stilbazolium 2,4,6-trimethylbenzenesulfonate), or OH1 (2-(3-(4-hydroxystyryl)-5,5-dimethyl-cyclohex-2-enylidene)malononitrile).

In this connection, the EO crystal 63 may be an inorganic crystal that does not have a natural birefringence, such as GaP (gallium phosphide), GaAs (Gallium arsenide), InP (indium phosphide), ZnTe (zinc telluride), or CdTe (cadmium telluride), or an organic crystal that does not have a natural birefringence.

In this connection, the EO crystal 63 has its optic axis match a polarization axis (here, match the axis direction of the polarization maintaining fiber 61 provided on the root side of the EO crystal 63). Thereby, a measurement target electromagnetic wave causes a refractive index change in the electro-optic crystal, which modulates the phase and amplitude of an input optical signal, thereby changing the optical signal.

Here, the crystal sides CR (in the X direction and the Y direction) of the EO crystal 63 are preferably set to 1/2 or less of the wavelength $\lambda$ (the intermediate value of the bandwidth) of the measurement target electromagnetic wave. In the case where the wavelength $\lambda$ of the measurement target electromagnetic wave is large (100 mm or more), disturbance by the EO sensor has a little influence. However, in the case where the wavelength $\lambda$ of the measurement target electromagnetic wave is short (less than 100 mm, especially, less than 25 mm), the disturbance by the EO sensor becomes a problem, depending on the crystal size. The inventor(s) of the present application has (have) confirmed that the influence of the disturbance on the measurement data is reduced to an allowable level by setting the crystal side CR to 1/2 or less of the wavelength $\lambda$, more preferably 1/4 or less of the wavelength $\lambda$. For example, in the case of using a crystal with the crystal side CR of 1 mm, the wavelength $\lambda$ of the measurement target electromagnetic wave is 0.5 mm or more (the frequency is less than 600 GHz), more preferably 0.25 mm or more (the frequency is less than 1200 GHz).

The reflection substrate 62X has a mirror film on its root side where the tip end surface 60Xa exists in the EO sensor 60X, and is configured to completely reflect an optical signal supplied from the root side back to the root side.

The EO crystal 63X is a crystal that exhibits an electro-optic effect, and changes the state of the optical signal according to an electromagnetic wave. The glass substrate 64X is used to reinforce the EO crystal 63X that is fragile. The collimator lens 65X converts a modulation optical signal supplied from the polarization maintaining fiber 61X into parallel light to allow the modulation optical signal to be reflected by the reflection substrate 62X. In this connection, the point on the reflection substrate 62X at which the modulation optical signal is reflected is referred to as a reflection point. That is, the reflection point is an extension of the center of the polarization maintaining fiber 61 in the X and Y directions, and is on the root-side surface of the reflection substrate 62X in the Z direction.

The polarization maintaining fibers 61A, 61X, 61Y, and 61Z are each connected to the center of the corresponding EO sensor 60A, 60X, 60Y, and 60Z with the optic axis matching the polarization axis, and the separation distances $\Delta X$, $\Delta Y$, and $\Delta Z$ are set to prescribed values.

The separation distances $\Delta X$, $\Delta Y$, and $\Delta Z$ are set to 1/2 or less of the wavelength $\lambda$ (the intermediate value of the bandwidth) of the measurement target electromagnetic wave. This is because this setting enables achieving an almost simultaneity property, which leads to highly accurate measurement. In addition, by setting the separation distances $\Delta X$, $\Delta Y$, and $\Delta Z$ to 1/3 or less of the wavelength $\lambda$, more preferably 1/4 or less of the wavelength $\lambda$, the simultaneity property is enhanced, which further improves the accuracy of detection of separation-distance-based differences. In addition, to reduce distortion in the measurement target electromagnetic wave caused due to the shape of the measurement probe 60, the separation distance $\Delta Z$ is preferably set to be less than the separation distances $\Delta X$ and $\Delta Y$.

As described earlier, the measurement target electromagnetic wave is an FMCW signal that is generated by frequency-modulating a triangle wave, and its frequency changes with time. Therefore, the bandwidth of a filter needs to be widened according to the frequency modulation, which increases the importance of enhancing the simultaneity property. Therefore, in the case where a modulated signal whose frequency changes with time is the measurement target electromagnetic wave, the separation distances $\Delta X$, $\Delta Y$, and $\Delta Z$ are preferably set to 1/4 or less of the wavelength $\lambda$.

In addition, in the case where a plurality of EO sensors are arranged with small separation distances $\Delta X$ and $\Delta Y$ (1/2 of the wavelength $\lambda$, especially, 1/4 of the wavelength $\lambda$), unlike the case of using a single EO sensor, the EO crystals 63 may interfere with each other. In order to reduce the interference, an inter-crystal distance CD, which is a separation distance between the EO crystals 63, is preferably set to 1/10 or less of the wavelength $\lambda$. If the inter-crystal distance CD is set large, the interference occurs and therefore the crystal side CR needs to be set small, which results in low manufacturability.

In addition, the probe size WS in the X and Y directions in the measurement probe 60 is preferably 1.5 times or less the wavelength $\lambda$ of the measurement target electromagnetic wave, more preferably equal to the wavelength $\lambda$, and even more preferably 1/2 or less of the wavelength $\lambda$. This is because a smaller probe size WS results in less disturbance to the measurement target electromagnetic wave.

More concretely, for example, in the case where the wavelength $\lambda$ and frequency of the measurement target electromagnetic wave and 5 mm and 60 GHz, respectively, the separation distances $\Delta X$ and $\Delta Y$ are set to 1/4 of the wavelength $\lambda$, i.e., 1.25 mm, and the separation distance $\Delta Z$ is set to 1/8 of the wavelength $\lambda$, i.e., 0.625 mm. In addition, the crystal side CR is set to 1/5 of the wavelength $\lambda$, i.e., 1.0 mm, the inter-crystal distance CD is set to 1/20 of the wavelength $\lambda$, i.e., 0.25 mm (1/4 of the crystal side CR), and the probe size WS is set to 0.45 times the wavelength $\lambda$, i.e., 2.25 mm (2.25 times the crystal side CR).

The polarization maintaining fibers 61A, 61X, 61Y, and 61Z connected to the four EO sensors 60A, 60X, 60Y, and 60Z are fixed by the fixing substrate 66 formed of an upper board 66A, an intermediate board 66B, and a lower board 66C.

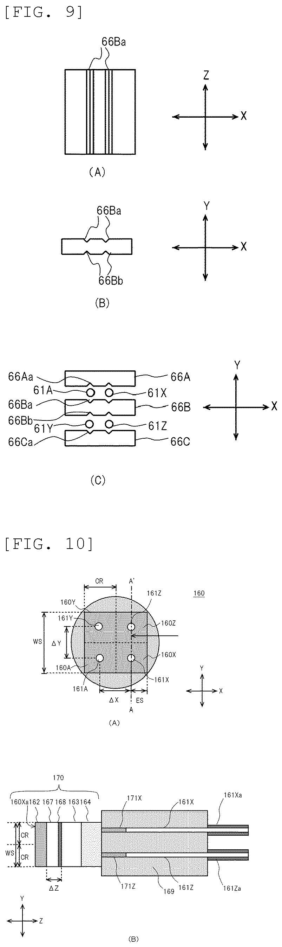

As illustrated in (A) to (C) of FIG. 9, the fixing substrate 66 is formed of three rectangular plate members as a whole, and two V-grooves 66Aa, 66Ba, 66Bb, 66Ca are formed in parallel to the z direction in the lower surface of the upper board 66A, the upper and lower surfaces of the intermediate board 66B, and the upper surface of the lower board 66C. These grooves each have a depth that is approximately 1/2 of the diameter $\varphi$ of the polarization maintaining fibers 61A, 61X, 61Y, and 61Z, and the shapes and sizes of the grooves are determined such that, when mating grooves 66Aa and 66Ba are brought together and mating grooves 66Bb and 66Ca are brought together, a slight gap (for example, about 1/10 to 1/50 of the diameter $\varphi$) is formed between the lower surface of the upper board 66A and the upper surface of the intermediate board 66B and between the lower surface of the intermediate board 66B and the lower board 66C. In this connection, the grooves 66Aa, 66Ba, 66Bb, and 66Ca may be notch grooves with trapezoidal cross sections or U-shaped grooves.

Therefore, under the state where the polarization maintaining fibers 61A and 61X are sandwiched by the lower surface of the upper board 66A and the upper surface of the intermediate board 66B and the polarization maintaining fibers 61Y and 61Z are sandwiched by the lower surface of the intermediate board 66B and the lower board 66C, these are fixed with a liquid adhesive or an adhesive sheet. In this way, the measurement probe 60 with the separation distances $\Delta X$ and $\Delta Y$ is made simply. At the time of the fixing, a spacer or a jig with a prescribed height for securing the thickness in the Y direction of the fixing substrate 66 may be used to improve the manufacturability.

In this connection, in the case of using a four-core measurement probe in which EO crystals are arranged with separation distances ΔX and ΔY of 1.25 mm, a probe size WS of 2.25 mm, a crystal side CR of 1.0 mm, and an inter-crystal distance CD of 0.25 mm and the reflection substrates have a thickness of 0.5 mm, a measurement was able to be performed on a measurement target electromagnetic wave with a frequency of 60 GHz (the wavelength λ is approximately 5.0 mm) and a measurement target electromagnetic wave with a frequency of 24 GHz (the wavelength λ is approximately 12.5 mm) .

As described above, by defining the positions of the polarization maintaining fibers 61 using the grooves formed in the fixing substrate 66, it becomes possible to improve the positioning accuracy for the very small EO sensors 60A, 60X, 60Y, and 60Z and to manufacture the measurement probe 60 with a simple process. In addition, a unique EO crystal 63 is used for each EO sensor 60A, 60X, 60Y, and 60Z, and therefore the measurement probe 60 is preferably used in the case where the frequency of the measurement target electromagnetic wave is 25 GHz or less, especially, 10 GHz or less.

(Second Embodiment)

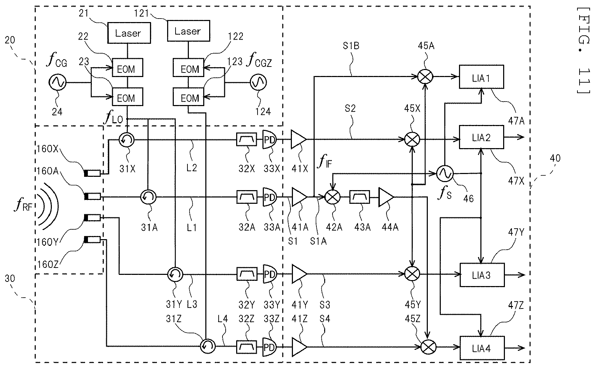

A second embodiment will now be described with reference to FIGS. 10 and 11. The second embodiment is different from the above-descried first embodiment in the configuration of a measurement probe and the frequency of an optical signal to be supplied to the measurement probe. In this connection, in the second embodiment, each constitutional element corresponding to that of the first embodiment is designated by the same reference numeral as in the first embodiment or a reference numeral obtained by adding 100 to the reference numeral used in the first embodiment, and the description of the same constitutional elements is omitted.

As illustrated in FIG. 10, a measurement probe 160 includes a single structure 170 formed of EO sensors 160A, 160X, 160Y, and 160Z. Polarization maintaining fibers 161 (161A, 161X, 161Y, and 161Z) are positioned at positions separated from one another by separation distances ΔX and ΔY, by a capillary 169 having four holes with almost the same diameter as the polarization maintaining fibers 161, and are fixed. Portions of the polarization maintaining fibers 161 closer to the root side than the capillary 169 are covered with resin coats 161a (161Aa, 161Xa, 161Ya, and 161Za).

That is, the four EO sensors 160A, 160X, 160Y, and 160Z are each formed as a prescribed sensor region having a polarization maintaining fiber 161 as a center in the structure 170. This means that the EO sensors 160A, 160X, 160Y, and 160Z each have a reflection point as an extension of a corresponding polarization maintaining fiber 161. In addition, on the tip end side of the capillary 169, collimator lenses 171 (171A, 171X, 171Y, and 171Z) having the same diameter as the polarization maintaining fibers 161 are arranged so that each collimator lens 171 is an extension of a corresponding polarization maintaining fiber 161.

For example, the collimator lenses 171 are fixed in advance to the tip ends of the polarization maintaining fibers 161 in a state where the polarization maintaining fibers 161 are yet to be covered with the resin coats 161a on the tip end sides thereof (that is, in a state where core members each including a core part and a cladding part covering the core part are exposed). The collimator lenses 171 are then inserted in the holes of the capillary 169 and fixed, so that the polarization maintaining fibers 161 and collimator lenses 171 are disposed. In addition, after the collimator lenses 171 are fixed inside the holes of the capillary 169 in advance, the polarization maintaining fibers 161 may be fixed inside the holes of the capillary 169. Alternatively, the collimator lenses 171 may be fixed after the polarization maintaining fibers 161 are fixed. After that, the tip end surface of the capillary 169 is polished and then is stuck to the root side of the structure 170, so that the four polarization maintaining fibers 161 are connected to the structure 170.

The structure 170 includes, in addition to the reflection substrate 162, EO crystal 163, and glass substrate 164, a sub-EO crystal 167 and a dielectric film 168 between the reflection substrate 162 and the EO crystal 163. The total thickness in the Z direction of the sub-EO crystal 167 and dielectric film 168 is set to a separation distance ΔZ. The dielectric film 168 has a base film and a dielectric layer (not illustrated). As the base film, an organic material such as polyimide or an inorganic material such as a glass film may be used as appropriate, for example. The base film has a thickness of approximately 10 to 50 μm, for example, and is formed of a material that allows the wavelength of a received optical signal to completely pass therethrough. In the dielectric film 168, the dielectric layer may be provided on either the tip end side or the root side. In this description, it is assumed that the dielectric layer is provided on the root-side surface.

The dielectric layer has a thickness of approximately 1 to 10 μm, for example, and has characteristics of reflecting almost 100% (90% or more) light of prescribed wavelength (for example, 1530 nm) and allowing almost 100% (90% or more) light of another wavelength (for example, 1580 nm) to pass therethrough. A dielectric layer that drastically changes its transmittance (from less than 10% to greater than 90%) in a range of wavelength from 30 to 100 nm is preferably used. In this connection, such a dielectric layer is not always needed as long as any thin film with reflectivity and transmittance is used.

As illustrated in FIG. 11, optical signals with different wavelengths are supplied to the EO sensors 160A, 160X, and 160Y, and the EO sensor 160Z. For example, a first input optical signal with a wavelength of 1530 nm is supplied to the EO sensors 160A, 160X, and 160Y, and a second input optical signal with a wavelength of 1580 nm is supplied to the EO sensor 160Z.

As a result, the first input optical signals supplied to the EO sensors 160A, 160X, and 160Y pass through the dielectric film 168 and are reflected at reflection points on the reflection substrate 162. The second input optical signal supplied to the EO sensor 160Z is reflected at a reflection point on the dielectric film 168. That is to say, the EO sensor 160Z is able to measure an electromagnetic wave at a position separated from the EO sensor 160A by the separation distance $\Delta Z$ in the Z direction.

In this connection, the first input optical signals E1A and E2A (frequencies $f\text{-}1(1)$ and $f\text{-}1(2)$) and the second input optical signals E1B and E2B (input frequencies $f\text{-}2(1)$ and $f\text{-}2(2)$) are supplied so that they have their constant values, irrespective of a differential frequency $f(\text{IF})$. Therefore, the wavelengths of the input optical signals do not vary, so that the dielectric layer has a fixed reflectivity.

As the measurement probe 160, a small probe may be made compared with the first embodiment. More specifically, for example, in the case where a measurement target electromagnetic wave has a wavelength $\lambda$ of 3 mm and a frequency of 100 GHz, the separation distances $\Delta X$ and $\Delta Y$ are set to 1/10 of the wavelength $\lambda$, i.e., 0.3 mm. In addition, the separation distance $\Delta Z$ is set to 1/20 of the wavelength $\lambda$, i.e., 0.15 mm.

In the present embodiment, it is assumed that each side in the X direction and Y direction of the sensor regions (represented by the broken lines) corresponding to the EO sensors 160A, 160X, and 160Y is taken as a crystal side CR. In the case where the measurement target electromagnetic wave has a wavelength $\lambda$ of 3 mm (about 100 GHz), the crystal side CR is preferably set to 1/2 or less of the wavelength $\lambda$, i.e., 1.5 mm or less, more preferably 1/4 or less of the wavelength $\lambda$, i.e., 0.75 mm or less. For example, in the case where the crystal side CR is 0.75 mm, the EO crystal 163 with each side (probe size WS) of 1.5 mm is used in the structure 170.

The probe sizes WS in the X and Y directions for the measurement probe 60 are preferably set to be twice or less the wavelength $\lambda$ of the measurement target electromagnetic wave, and more preferably set to be equal to the wavelength $\lambda$ or less. This enables reducing disturbance to a measurement target electromagnetic wave. In this connection, with respect to each separation distance $\Delta X$ and $\Delta Y$, an outer edge distance ES from a reflection point to the outer edge of the EO crystal in the X or Y direction is preferably three times or less the wavelength $\lambda$ of the measurement target electromagnetic wave, more preferably twice or less the wavelength $\lambda$, and even more preferably less than or equal to the wavelength $\lambda$. This makes it possible to reduce the probe size WS and to reduce the disturbance to the measurement target electromagnetic wave.

In the measurement probe 160, one EO crystal is used as a plurality of EO sensors. This eliminates the need of forming a gap between the EO sensors, and makes it possible to reduce disturbance to a measurement target electromagnetic wave caused due to diffraction between the plurality of EO sensors and to manufacture a very small measurement probe with the EO sensor that is easy to handle.

In this connection, in the case of using a four-core EO sensor that has an EO crystal with separation distances $\Delta X$ and $\Delta Y$ of 0.5 mm, a probe size WS of 1.5 mm, and a crystal side CR of 0.75 mm and a reflection substrate with a thickness of 0.5 mm, a measurement was able to performed on a measurement target electromagnetic wave with a frequency of 120 GHz (a wavelength of approximately 2.5 mm). In addition, in the case of using a four-core EO sensor that has an EO crystal with separation distances $\Delta X$ and $\Delta Y$ of 0.25 mm, a probe size WS of 0.5 mm, and a crystal side CR of 0.25 mm and a reflection substrate (polyimide film) with a thickness of 25 $\mu$m, a measurement was able to be performed on a measurement target electromagnetic wave with a frequency of 300 GHz (a wavelength of approximately 1 mm).

As described above, by connecting the four polarization maintaining fibers 161 arranged in advance at prescribed positions to the single structure 170, it becomes possible to reduce the size of the measurement probe 160. The reduction in the size of the measurement probe 160 efficiently reduces distortion in a measurement target electromagnetic wave, and especially, the measurement probe 160 is suitably used for a measurement target electromagnetic wave of high frequency. Since one EO crystal 163 is used in the measurement probe 160, the measurement probe 160 is suitably used for a measurement target electromagnetic wave with a frequency of 10 GHz or more, especially, a frequency of 25 GHz or more.

<Verification through Simulation>

The following describes results of verifying a measurement probe through simulation.

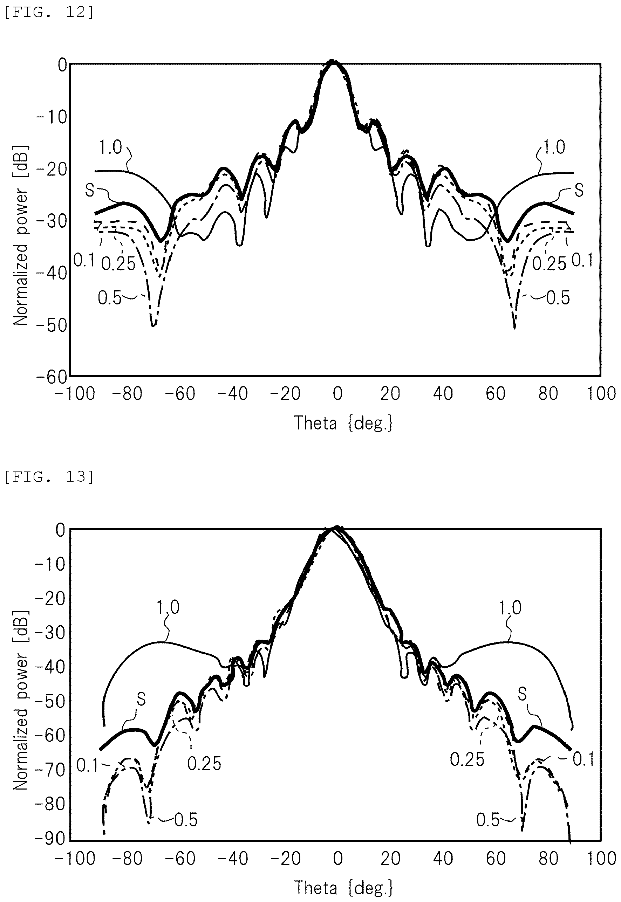

FIGS. 12 and 13 illustrate a case where an electromagnetic wave is emitted from a 300 GHz horn antenna, a near-field is measured using measurement probes with different separation distances, and a far-field is computed on the basis of the measurement results. The computation is performed while changing the separation distances $\Delta X$ and $\Delta Y$. FIG. 12 illustrates an E plane (x-z plane), whereas FIG. 13 illustrates an H plane (y-z plane).

Curves indicated by "S" in the graphs represent simulated values of an electromagnetic wave emitted from the 300 GHz horn antenna. The other curves represent the far-field computed using the results of measuring the near-field while changing the separation distances $\Delta X$ and $\Delta Y$.

Numbers "0.1," "0.25," "0.5," and "1.0" in the graphs are the separation distances $\Delta X$ and $\Delta Y$ and have the

units of mm. Since 300 GHz corresponds to a wavelength of 1.0 mm, the separation distances ΔX and ΔY of "0.1," "0.25," "0.5," and "1.0" are λ/10, λ/4, λ/2, and 1λ, respectively.

As seen in the graphs, the values obtained with respect to "0.1" and "0.25" do not have big differences and have curves similar to the simulated values. The values obtained with respect to "0.5" have a large deviation from the simulated values, and the values obtained with respect to "1.0" have a large deviation at side lobes except the first lobe.

As seen from the above results, it is preferable that the separation distances ΔX and ΔY are set to be less than λ/2, especially, less than or equal to λ/3.

(Experimental Examples)

The following describes results of actually making probes proposed in the embodiments and performing measurements.

The probe 60 illustrated in FIG. 8 was made as a first experimental probe 1. This probe was a four-core measurement probe in which EO crystals were arranged with separation distances ΔX and ΔY of 1.25 mm, a probe size WS of 2.25 mm, a crystal side CR of 1.0 mm, and an inter-crystal distance CD of 0.25 mm, and reflection substrates have a thickness of 0.5 mm.

A far-field at 76.5 GHz was measured using the first experimental probe 1. Since 76.5 GHz corresponds to a wavelength of approximately 3.92 mm, the separation distances ΔX and ΔY was approximately 0.32 λ (approximately λ/3).

"PO" represents data measured with a conventional reference probe as a reference (individual probe), whereas O ports of an all-in-one probe (experimental probe 1) are taken as individual probes. A large distortion is seen as compared with the measurement using one individual probe (experimental probe 1).

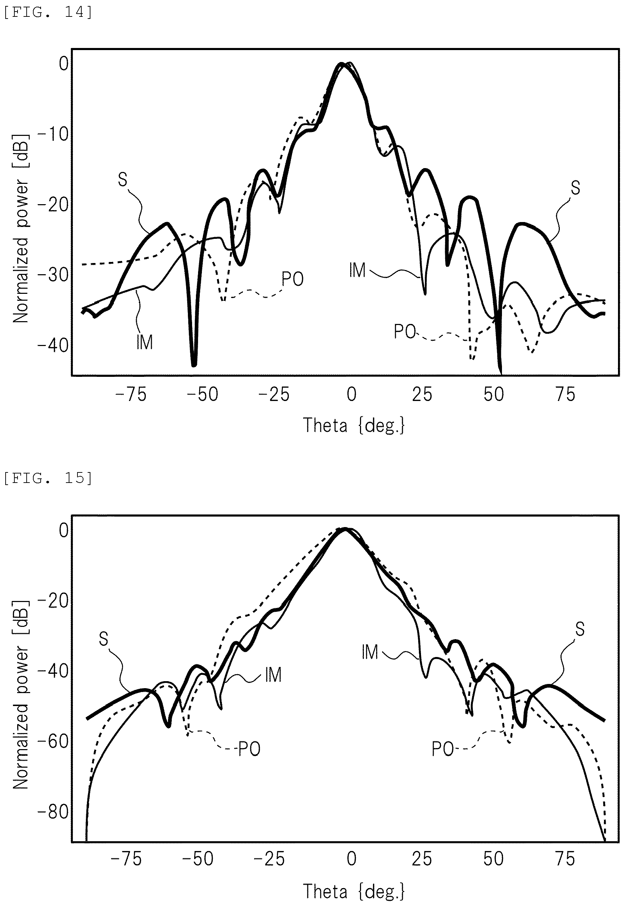

FIGS. 14 and 15 are graphs representing simulated values ("S" in the drawings) and measured values ("IM" in the drawings) in the E-plane and H-plane. In addition, the table 1 shows comparison between the simulated values and the measured values.

(Table 1)

|  |  |  | Simulation | 3D-Probe | Difference |
|---|---|---|---|---|---|
| H-plane half width[deg.] |  |  | 12.2 | 10.7 | 1.5 |
| E-plane half width[deg.] |  |  | 10.8 | 10.3 | 0.5 |
| E-plane | +1st Side robe | Position[deg.] | 13.5 | 18.3 | 4.8 |
|  |  | Ratio of the Main robe [dB] | -9.5 | -10.5 | 1.0 |
|  | -1st Side robe | Position [deg.] | -13.5 | -13.0 | 1.5 |
|  |  | Ratio of the Main robe [dB] | -9.5 | -7.6 | 1.9 |

In addition, the probe 160 illustrated in FIG. 10 was made as an experimental probe 2. This probe was a four-core EO sensor that had an EO crystal with separation distances ΔX and ΔY of 0.25 mm, a probe size WS of 0.5 mm, and a crystal side CR of 0.25 mm, and a reflection substrate (polyimide film) with a thickness of 25 μm.

Since the frequency 300 GHz of the measurement target electromagnetic wave corresponds to a wavelength λ of approximately 1 mm, the crystal side CR was approximately 0.25A (λ/4), and the separation distances ΔX and ΔY were approximately 0.25λ (λ/4).

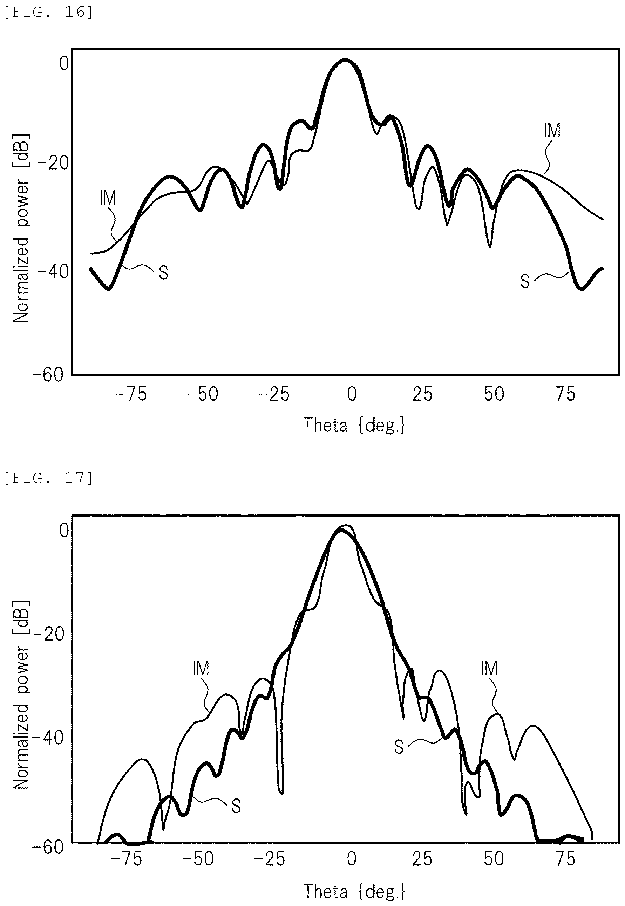

FIGS. 16 and 17 are graphs representing simulated values ("S" in the drawings) and measured values ("IM" in the drawings) in the E-plane and H-plane. In addition, the table 2 shows comparison between the simulated values and the measured values.

(Table 2)

|  | Simulation | 3D-Probe | Difference |
|---|---|---|---|
| H-plane half width[deg.] | 9.7 | 9.5 | 0.2 |
| E-plane half width[deg.] | 10.2 | 10.4 | 0.2 |

(continued)

|  |  |  | Simulation | 3D-Probe | Difference |
|---|---|---|---|---|---|
| E-plane | +1st Side robe | Position[deg.] | 15.4 | 15.9 | 0.5 |
|  |  | Ratio of the Main robe [dB] | -11.4 | -11.0 | 0.4 |
|  | -1st Side robe | Position [deg.] | -15.4 | -16.4 | 1.0 |
|  |  | Ratio of the Main robe [dB] | -11.4 | -16.9 | 5.5 |

As seen in the tables 1 and 2, the comparison between the experimental probe 1 and the experimental probe 2 shows that the experimental probe 2 has smaller differences between the simulated values and the measured values, irrespective of a smaller wavelength and a higher frequency band that is likely to cause big noise. It is therefore confirmed that the experimental probe 2 using one crystal has better performance as a probe.

In addition, a measurement at 79 GHz (a wavelength of 3.8 mm) was performed using a 2D probe in which three optical fibers were connected to one crystal (with separation distances $\Delta X$ and $\Delta Y$ of 0.5 mm). The separation distances $\Delta X$ and $\Delta Y$ of this time were approximately $0.13\lambda$ (approximately $\lambda/8$).

Although the separation distances $\Delta X$ and $\Delta Y$ were set to be sufficiently small values, i.e., $\lambda/4$ or less, distortion was confirmed and thus the measurement was not done with high accuracy. It is considered that since the separation distances $\Delta X$ and $\Delta Y$ were set to $\lambda/4$ or less, disturbance caused by the probe itself had a small influence but the restoration accuracy of a phase decreased. In view of the above, the best separation distances $\Delta X$ and $\Delta Y$ are about $\lambda/4$, and especially, are preferably in a range of $\lambda/6$ to $\lambda/3$, inclusive. Similarly, the best crystal size CR is about $\lambda/4$, and especially, is preferably in a range of $\lambda/6$ to $\lambda/3$, inclusive.

(Operations and Effects)

The features of the invention derived from the above-described embodiments will now be described, using problems, effects, and others according to necessity. In the following description, corresponding units in the above embodiments are indicated in parentheses for easily understanding, but the configuration is not limited to the specific units indicated in the parentheses. In addition, the meanings of terms, examples, and others described for each feature may apply to those described for the other features.

The measurement probe (measurement probe 60) of the present invention is a measurement probe that is used in an electromagnetic wave measurement system that measures a change in an optical signal caused by electro-optic effect according to a measurement target electromagnetic wave, using the measurement probe including a first measurement unit (EO sensor 60A and polarization maintaining fiber 61A) and a second measurement unit (EO sensor 60X, 60Y, 60Z and polarization maintaining fiber 61X, 61Y, 61Z) and measures the spatial distribution characteristics of the measurement target electromagnetic wave, based on differential values of the optical signal detected while moving the measurement probe. The measurement probe is characterized by including

the first measurement unit having a sensor structure including an electro-optic crystal (EO crystal 63A, 63X, 63Y, 63Z) that exhibits the electro-optic effect, an optical fiber (polarization maintaining fiber 61A) that is provided on the root side of the electro-optic crystal and is configured to transmit the optical signal, and a reflection unit (reflection substrate 62A) that is provided on the tip end side of the electro-optic crystal and is configured to reflect the optical signal, and

the second measurement unit having the sensor structure, and

in first and second directions perpendicular to the axis direction of the optical fiber, a size of the electro-optic crystal is set to 1/2 or less of a wavelength of the measurement target electromagnetic wave.

In this connection, the root side of the electro-optic crystal may be a side closer to the root than the electro-optic crystal, and optical components (reinforcing glass, collimator lens, fiber connection member, and others) may be disposed between the electro-optic crystal and the optical fiber.

With this configuration, preferable separation-distance-based differences may be obtained with small noise.

The measurement probe is characterized in that two optical signals with different frequencies are input to the electro-optic crystals included in the first and second measurement units, respectively.

The measurement probe is characterized in that a separation distance (separation distance $\Delta X$, $\Delta Y$, $\Delta Z$) between a first reflection point where the optical signal is reflected in the first measurement unit and a second reflection point where the optical signal is reflected in the second measurement unit is set to 1/2 or less of the wavelength of the measurement electromagnetic wave.

With this configuration, the simultaneity of the optical signals obtained by the first measurement unit and the second measurement unit may be ensured, which enables the measurement of the separation-distance-based difference with high accuracy.

The measurement probe is characterized in that the separation distance is set to 1/3 or less of the wavelength of the measurement target electromagnetic wave.

With this configuration, the simultaneity may be enhanced, which enables the measurement with higher accuracy.

Two optical signals with different frequencies are input to the electro-optic crystals in the first and second measurement units, respectively. Therefore, the two optical signals are easily converted into a frequency domain that is manageable as an electrical signal.

The measurement probe is characterized in that the two optical signals are input to the first optical fiber and the second optical fiber, respectively, in a state where they are adjusted so that a differential frequency obtained by subtracting the frequency of the measurement target electromagnetic wave from the difference between the frequencies of the two input signals maintains constant.

With this configuration, since the differential value is computed from an electrical signal whose frequency is the constant differential frequency, the subsequent processing may be simplified and thus the computation accuracy of the differential value may be improved.

The measurement probe is characterized in that the reflection unit in the first measurement unit and the reflection unit in the second measurement unit are
arranged separated from each other by a reflection separation distance in a third direction parallel to the axis direction of the first and second optical fibers, and the reflection separation distance is set to 1/2 or less of the wavelength of the measurement target electromagnetic wave.

With this configuration, the spatial distribution characteristics of the measurement target electromagnetic wave in the third direction may be detected based on the differential value between the first and second measurement unit.

The measurement probe is characterized in that the reflection separation distance is set to be less than the separation distance.

With this configuration, the shape difference (unevenness) of the first and second measurement units in the Z direction may be reduced, and thus the influences of the first and second measurement units on the measurement target electromagnetic wave may be reduced.

The measurement probe is characterized by further including a third measurement unit having the sensor structure and including a third optical fiber disposed separated from the first optical fiber by the separation distance in a second direction perpendicular to the first direction in which the first and second measurement units are arranged, and a unit formed by stacking one another an intermediate board having a first surface and a second surface opposite to the first surface, a first board, and a second board, the first surface having formed therein two grooves which first and second optical fibers fit, the second surface having formed therein a groove which a third optical fiber fits, the first board having a surface that faces the first surface of the intermediate board and has formed therein two grooves at positions facing the two grooves of the first surface, the second board having a surface that faces the second surface of the intermediate board and has formed therein a groove at a position facing the groove of the second surface, wherein the first and second optical fibers are each sandwiched by the grooves of the intermediate board and the first board, and the third optical fiber is sandwiched by the grooves of the intermediate board and the second board.

With this configuration, the three optical fibers arranged in at least two directions may be positioned with ease and with high accuracy.

The measurement probe is characterized in that the two grooves formed in the first surface of the intermediate board are located with the separation distance therebetween, and
the thickness of the intermediate board from the first surface and the second surface is approximately equal to the separation distance.

With this configuration, the thickness of the intermediate board may be helpful in positioning the three optical fibers, which are arranged in at least two directions, with ease and with high accuracy.

The measurement probe is characterized by including a fourth measurement unit having the sensor structure and including a fourth optical fiber that is disposed separated from the first optical fiber by the separation distance in the first and second directions and the reflection unit disposed separated from the first measurement unit by the reflection separation distance in the third direction that is the axis direction of the first optical fiber.

With this configuration, in the three-dimensional measurement probe with the four optical fibers, the four optical fibers may be positioned with ease and with high accuracy.

The measurement probe is characterized in that the first and second optical fibers are connected to one electro-optic crystal.

With this configuration, the measurement probe may be manufactured with a simple step of connecting the previously positioned first and second optical fibers. In addition, the number of components may be reduced, so that a much smaller measurement probe may be manufactured at a low cost.

The measurement probe is characterized in that the first and second optical fibers penetrate a capillary having holes that are approximately identical in size to the first and second optical fibers.

With this configuration, the measurement probe may be manufactured with a simple step of connecting the optical fibers to a structure made of the electro-optic crystal and the reflection unit.

The measurement probe is characterized in that the one electro-optic crystal has a functional film (dielectric layer) positioned separated from the reflection unit disposed on the tip end side by the reflection separation distance in the third direction that is the axis direction of the first and second optical fibers,

the reflection separation distance is set to 1/2 or less of the wavelength of the measurement target electromagnetic wave, and

the functional film allows an optical signal of a wavelength transmitted to the first measurement unit to pass therethrough and reflects an optical signal of a wavelength transmitted to the second measurement unit.

With this configuration, the first and second measurement units may be formed as a single structure and the reflection unit may be separated in the third direction.

The measurement probe is characterized in that the first to fourth optical fibers are connected to the one electro-optic crystal at positions separated one from another by the separation distance,

the functional film is provided separated from the reflection unit disposed on the tip end side by the reflection separation distance in the third direction that is the axis direction of the first and second optical fibers,

the reflection separation distance is set to 1/2 or less of the wavelength of the measurement target electromagnetic wave, and

the first to fourth optical fibers are embedded in one capillary.

With this configuration, since the first to fourth optical fibers are positioned in advance in the first and second directions, the measurement probe may be manufactured with a simple step of connecting them to the electro-optic crystal.

The measurement probe is characterized in that the first and second measurement units have tip end surfaces on the tip end sides thereof and the tip end surfaces are flush with each other.

With this configuration, the spatial distribution characteristics of the electromagnetic wave may be measured with causing as less influence on the measurement target electromagnetic wave as possible.

The measurement probe is characterized in that the functional film is provided separated from the tip end surface by the reflection separation distance as an extension of the second optical fiber parallel to the third direction that is the axis direction of the first and second optical fibers, and such a functional film is not provided as an extension of the first optical fiber.

With this configuration, the first and second measurement units are formed as a single structure with their tip end surfaces being flush with each other, and their reflection units may be separated in the third direction.

An electromagnetic wave measurement system (electromagnetic wave measurement system 1) includes a measurement probe including a first measurement unit having a sensor structure including an electro-optic crystal that exhibits an electro-optic effect, an optical fiber that is provided on a root side of the electro-optic crystal and is configured to transmit the optical signal, and a reflection unit provided on a tip end side of the electro-optic crystal, a second measurement unit having the sensor structure, wherein a separation distance between a first reflection point at which the optical signal is reflected in the first measurement unit and a second reflection unit at which the optical signal is reflected in the second measurement unit is set to 1/2 or less of a wavelength of the measurement target electromagnetic wave,

a difference detection unit (optical signal processing unit 30) that detects a differential value representing a change in the optical signal caused by the electro-optic crystals between the first measurement unit and the second measurement unit, and

an electromagnetic wave characteristic computing unit (electrical signal processing unit 40, computing device 3) that computes the electromagnetic wave characteristics of the electromagnetic wave, based on differential values of the optical signal detected while moving the measurement probe.

With this configuration, the electromagnetic wave measurement system is able to compare identical waves in the measurement target electromagnetic wave, so that the influence of noise (changes of the wave itself such as the width, amplitude, an others of the wave) appearing in the wave itself may be eliminated without fail.

The electromagnetic wave measurement system is characterized in that two optical signals with different frequencies are input to the first optical fiber and the second optical fiber, respectively.

With this configuration, the two optical signals may be converted into a frequency domain that is manageable as an electrical signal.

The electromagnetic wave management system is characterized by including a driving unit that drives the measurement probe, wherein the difference detection unit detects the differential value at timing when the moving distance of the measurement probe reaches a value less than the separation distance.

As a result, the waveform of the measurement target electromagnetic wave may be restored with a sampling theorem.

Optical fibers of the present invention include a plurality of fiber core members each including a core part configured to transmit an optical signal and a cladding part that covers the core part and has a different refractive index from the core part, and
a capillary that has a plurality of holes, the holes being approximately identical in size to the fiber core members, and that fixes the plurality of fiber core members in a state where the plurality of fiber core members are inserted into the holes.

With this configuration, the plurality of fiber core members may be fixed in the state where they are positioned in advance. Therefore, the plurality of optical fibers may be connected to a variety of sensors with ease.

The optical fibers are characterized in that an optical component that is approximately identical in size to the plurality of fiber core members is inserted into a tip end portion of the capillary.

With this configuration, the plurality of fiber core members and the optical component may be fixed where they are positioned in advance.

The optical fibers are characterized in that the tip end surface of the capillary is flush with the tip end surfaces of the fiber core members or the optical component inserted into the holes.

With this configuration, a sensor and a plurality of optical fibers may be connected with a simple step of attaching the tip end surfaces of the fibers to the root-side surface of the sensor.

With the recent spread of millimeter wave radars, there has been an increasing need of measuring the spatial distribution characteristics (amplitude and phase, intensity, frequency, and others in one dimension, two dimensions, and three dimensions) of electromagnetic waves that are high frequency waves such as millimeter waves with high accuracy. To meet the need, there is known a method of measuring the spatial distribution characteristics of electromagnetic waves using so-called electro-optic crystals that exhibit an electro-optic effect that is produced when light acts on a material influenced by electromagnetic waves (see, for example, PTL1).

In general, electro-optic crystals are poor workability and fragile. Especially, micromachining at the level of 1 mm or less is very difficult. However, the influence of disturbance by the measurement probe increases with a decrease in the wavelength of the measurement target electromagnetic wave. This is a problem.

The present invention is designed to solve the above problem, and intends to provide an electromagnetic wave measurement probe that is able to reduce the influence of disturbance and an electromagnetic wave measurement system using the electromagnetic wave measurement probe.

The measurement probe of the present invention is a measurement probe used in an electronic wave measurement system. The measurement probe includes
a first measurement unit having a sensor structure including an electro-optic crystal that exhibits an electro-optic effect, an optical fiber that is provided on the root side of the electro-optic crystal and is configured to transmit an optical signal, and a reflection unit that is provided on the tip end side of the electro-optic crystal and is configured to reflect the optical signal,
a second measurement unit having the sensor structure,
wherein the first and second optical fibers are connected to the root side of one electro-optic crystal.

Since the one EO crystal is usable as a plurality of EO sensors, it functions as a plurality of EO sensors with completely the same permittivity. Therefore, a very small measurement probe may be manufactured, in which the plurality of EO sensors do not interfere with each other. In addition, since there is no gap between the EO sensors, disturbance to the measurement target electromagnetic wave may be reduced.

(Other Embodiments)

The above-described embodiments use the electromagnetic wave measurement system 1 for examining the in-vehicle radar 4A. The present invention is not limited thereto and, for example, may be applicable for examining a variety of radars including radars installed on runways or roads and radars for aircrafts, and radio wave generators other than the radars, such as antennas. In addition, as a radar that emits an electromagnetic wave signal, not only a radar that emits an FMCW signal but also a radar that emits a signal with a single frequency may be examined in the present invention. In short, the invention is applicable for measuring the spatial distribution characteristics of an electromagnetic wave by detecting, as differential values between a plurality of electro-optic crystals, changes in an optical signal caused by the measurement target electromagnetic wave.

In addition, the above-described embodiments have described the case where feedback control is exercised so that the differential frequency $f(IF)$ component maintains constant. The present invention is not limited thereto and the feedback control is not always needed. The differential frequency $f(IF)$ component may be modified with maintaining input optical signals with modulation frequencies $f(1)$ and $f(2)$ constant. Even in this case, the differential frequency $f(IF)$ component is offset and is replaced with a base signal of a base frequency $f(s)$ in the subsequent processing. Therefore, separation-distance-based differences may theoretically be detected without any problems.

The above-described embodiments have described the case where two optical signals are used for one EO sensor. The present invention is not limited thereto and, for example, only one optical signal may be used for one EO sensor. In short, the present invention is applicable in all systems that detect a differential value representing a change in the optical signal due to the influence of an electromagnetic wave between two EO sensors.

The above-described embodiments have described the case where the four EO sensors 60A, 60X, 60Y, and 60Z are provided in the measurement probe 60. The present invention is not limited thereto and, for example, the measurement probe may be configured with two or three EO sensors separated by the separation distance $\Delta X$ or $\Delta Y$ in the X direction or Y direction, with two EO sensors separated by the separation distance $\Delta Z$ in the Z direction, with three EO sensors separated by the separation distances $\Delta X$ and $\Delta Z$, or with five or more EO sensors. Even such a configuration provides the same effects as the above-described embodiments. Similarly, for example, the measurement probe 160 may be configured with two or three EO sensors separated by the separation distances $\Delta X$, $\Delta Y$, and $\Delta Z$, or with five or more EO sensors separated by distances that are each several times one of the separation distances $\Delta X$, $\Delta Y$, and $\Delta Z$.

The above-described embodiments have described the case where the tip end surface of the EO sensor 60Z is back from the other EO sensors 60A, 60X, and 60Y. The present invention is not limited thereto, and for example, by fixing an optical component to the EP sensor 60Z at a position closer to the tip end side than the reflection substrate, the tip end surface of the EO sensor 60Z may be positioned so as to be flush with or protrude from the others in the Z direction. By doing so, the tip end surfaces of the four EO sensors 60A, 60X, 60Y, and 60Z may be flush with each other, so as to reduce distortion in the measurement target electromagnetic wave.

The above-described embodiments have described the case where the dielectric film is provided entirely on the XY plane of the structure 170. The present invention is not limited thereto and, a dielectric film may be formed only in a region corresponding to the EO sensor 160Z, or a dielectric film may be formed in a region corresponding to the EO sensor 160Z and a permeable film for allowing the second input optical signal to pass therethrough may be formed on the remaining region. In this case, two optical signals with the same frequency may be supplied to the four EO sensors, as in the first embodiment. The tip end surfaces may be formed as a single surface, so as not to cause distortion in the electromagnetic wave due to the shape (e.g., only the tip end surface of the EO sensor 160Z is located at a different position). In this connection, as the dielectric film of this case, any reflection film that reflects an optical signal may be used simply.

The above-described embodiments have described the case where the polarization maintaining fibers 61 are positioned using the grooves 66Aa to 66Ca. The present invention is not limited thereto and the polarization maintaining fibers 61 may be positioned using a variety of other methods. In addition, the above-described embodiments have described the case where the polarization maintaining fibers 161 are positioned using the holes formed in advance in the capillary 169. The present invention is not limited thereto and the polarization maintaining fibers 161 may be positioned using a variety of other methods. Needless to say, the first and second embodiments may be combined as appropriate. For example, a fixing substrate having grooves formed therein may be used for the structure 170, or four EO sensors may be positioned using a capillary having four holes.

The above-described embodiments have described the case where the separation-distance-based differences are detected at prescribed intervals while continuously moving the measurement probe 60. The present invention is not limited thereto and, while moving the measurement probe 60 little by little, separation-distance-based differences may be detected at each position of the measurement probe. In addition, the measurement probe does not always need to move and, for example, an electromagnetic wave generation device that emits a measurement target electromagnetic wave may be caused to move, as long as the measurement probe and the measurement target electromagnetic wave move relative to each other.

The above-described embodiments have described the case where the four polarization maintaining fibers are arranged in a grid. The present invention is not limited to thereto and, for example, the polarization maintaining fibers in an upper row and the polarization maintaining fibers in a lower row may be separated in the Y direction. Alternatively, three polarization maintaining fibers may be arranged in a triangle.

The above-described embodiments have described the case where each polarization maintaining fiber is connected to the center of an EO crystal 63 or the center of a sensor region. The present invention is not limited thereto, and the polarization maintaining fibers may be connected at positions closer to the center of the structure. That is, there is no restrictions on the positional relationship of the polarization maintaining fibers with the electro-optic crystals. In addition, the crystal size does not need be set to 1/2 or less of the wavelength $\lambda$ of the measurement target electromagnetic wave.

The above-described embodiments have described the case where as an electro-optic effect, the phase modulation of an optical signal is performed by refractive index changes. The present invention is not limited thereto and, for example, the polarization state of the optical signal may be changed. In addition, as the electro-optic effect, either of the Kerr effect in which the refractive index is proportional to the square of an electric field and the Pockels effect in which the refractive index is proportional to an electric field may be used. In addition, the electro-optic crystals may be formed in a variety of shapes such as cube, cuboid, column, and prism, and a ratio of lengths in the X, Y, and Z directions is not limited to any particular ratio.

The above-described embodiments have described the case where the reflection film is provided on the reflection substrate 62. The present invention is not limited thereto and a reflection film may be formed and be attached to a thin film material such as an inorganic material for a plastic film (for example, polyimide film) or a thin film, or a reflection film may be provided directly on the tip end surface 60a of the EO crystal 63 with a technique like spin coating, dip coating, vapor deposition, or another. By doing so, the influence of the base (glass or others) of the reflection substrate 62 on the measurement target electromagnetic wave may be reduced. In addition, in the case of forming a reflection film on a thin film material, the thin film is set to 200 $\mu$m or less, especially, 100 $\mu$m or less. By doing so, the influence of the thin film material on the measurement target electromagnetic wave may be minimized. In addition, a material with low permittivity (close to 1.0) is preferably selected as the thin film material. In the case of using an organic material (plastic material) as the thin film material, a metallized film or a copper foil film that is inexpensive and is easy to process may be used, so that the reflection film may be formed with ease and at a low cost.

The above-described embodiments have described the case of using a measurement probe for a differential measurement. The present invention is not limited thereto, and the measurement probe of the present invention may be used for a measurement of synchronous absolute values using a measurement target electromagnetic wave. For example, the measurement probe of this invention may be used as a probe that performs measurements at a plurality of measurement points simultaneously. Even this case provides an effect of the invention, i.e., a reduction in disturbance to the measurement target electromagnetic wave.

The above-described embodiments use one measurement probe 60 in the electromagnetic wave measurement system 1. The present invention is not limited thereto, and a measurement may be performed at a plurality of positions simultaneously using a plurality of measurement probes 60.

The above-described embodiments use the EO sensors 160A, 160X, 160Y, and 160Z in the electromagnetic wave measurement system 1. The present invention is not limited thereto, and bundled optical fibers may be employed, which includes a plurality of fiber core members each having a core part configured to transmit an optical signal and a cladding part that covers the core part and has a different refractive index from the core part, and a capillary that have a plurality of holes approximately identical in size to the fiber core members and fixes the plurality of fiber core members in a state where the plurality of fiber core members are inserted in the plurality of holes, and for example. The bundled optical fibers may be used as EO sensors in an electromagnetic wave measurement system having another configuration. Here, an optical component approximately identical in size to the fiber core members may be preferably inserted in the tip end portion of the capillary. In this case, the tip end surface of the capillary is preferably flush with the tip end surfaces of the fiber core members or the optical component inserted in the hole.

With this configuration, the bundled optical fibers that function as sensors in a variety of measurements and have a simple configuration may be manufactured.

The above embodiments have described the case where the measurement probe 60 used as a measurement probe is formed of the EO sensor 60A serving as a first measurement unit and the EO sensor 60X serving as a second measurement unit. The present invention is not limited thereto, and the measurement probe of the present invention may be formed of first and second measurement units having other various configurations.

Industrial Applicability

The present invention is applicable to an electromagnetic wave measurement probe that is used to measure the electronic wave of an in-vehicle radar, for example.

Reference Signs List

1: Electromagnetic wave measurement system, 2: Electromagnetic wave measurement device, 3: Computing device, 4: Automobile, 4A: Radar, 20: Optical signal supply unit, 21: Laser light source, 24: Synthesizer, 30: Optical signal processing unit, 31: Circulator, 32A: Optical filter, 33A: Photodiode, 40: Electrical signal processing unit, 41A: Amplifier, 41X: Amplifier, 42A: Multiplexer, 43A: Filter, 44A: Amplifier, 45X: Mixer, 46: Base signal generation unit, 47X: Lock-in amplifier, 50: Control unit, 51: Driving unit, 52: External interface, 60: Measurement probe, 60A, 60X, 60X, 60Z: EO sensor, 60Xa: tip end surface, 61, 61A, 61X, 61Y, 61Z: polarization maintaining fiber, 62X: Reflection substrate, 63X: EO crystal, 64X: Glass substrate, 65X: Collimator lens, 66: Fixing substrate, 66A: Upper board, 66Aa: Groove, 66B: Intermediate board, 66Ba, 66Bb, 66Ca: Groove, 66C: Lower board

**Claims**

1.   A measurement probe used in an electromagnetic wave measurement system, the measurement probe comprising:

a first measurement unit including a first electro-optic crystal that exhibits an electro-optic effect, a first optical fiber that is provided on a root side of the first electro-optic crystal and is configured to transmit an optical signal, and a reflection unit that is provided on a tip side of the first electro-optic crystal and is configured to reflect the optical signal; and

a second measurement unit including a second electro-optic crystal, a second optical fiber, and a second reflection unit,

wherein the first and second electro-optic crystals form one electro-optic crystal, and the first and second optical fibers are connected to a root side of the one electro-optic crystal.

2. The measurement probe according to claim 1, further comprising a capillary that has formed therein a plurality of holes approximately identical in size to fiber core members included in the first and second optical fibers and that fixes the first and second optical fibers in a state where the fiber core members are inserted in the plurality of holes.

3. The measurement probe according to claim 2, wherein a plurality of optical components are inserted in a tip end portion of the capillary, the plurality of optical components being approximately identical in size to the plurality of fiber core members.

4. The measurement probe according to claim 2 or 3, a tip end surface of the capillary and tip end surfaces of the fiber core members or the optical components inserted in the holes are flush with each other.

5. The measurement probe according to claim 1, wherein a separation distance between a first reflection point where the optical signal is reflected in the first measurement unit and a second reflection point where the optical signal is reflected in the second measurement unit is set to 1/2 or less of the wavelength of the measurement electromagnetic wave.

6. The measurement probe according to claim 1, wherein the one electro-optic crystal includes a functional film that is disposed separated from the reflection units disposed on the tip side and that allows an optical signal of a wavelength transmitted to the first measurement unit to pass therethrough and reflects an optical signal of a wavelength transmitted to the second measurement unit.

7. The measurement probe according to claim 6, wherein the one electro-optic crystal includes

the functional film that is disposed separated from the reflection units disposed on the tip side and that allows the optical signal of the wavelength transmitted to the first measurement unit to pass therethrough and reflects the optical signal of the wavelength transmitted to the second measurement unit, and

a third measurement unit to which an optical signal whose wavelength is identical to the wavelength transmitted to the first measurement unit is input.

[FIG. 1]

[FIG. 2]

[FIG. 3]

2

| 20 | OPTICAL SIGNAL SUPPLY UNIT | | | |

| 60 | MEASUREMENT PROBES | 30 OPTICAL SIGNAL PROCESSING UNIT | 40 ELECTRICAL SIGNAL PROCESSING UNIT |

| 51 | DRIVING UNIT | CONTROL UNIT | EXTERNAL INTERFACE |

50

52

[FIG. 4]

2

Y

X

Z

[FIG. 5]

1060

1061Y

1061Z

1060Ya

1060Y

1061X

1061A

ΔY

1060A

1060Aa

1060A

ΔX

1060Z

1060Za

1060Xa

1060X

ΔZ

Y

Z

X

[FIG. 6]

[FIG. 7]

[FIG. 8]

(A)

(B)

[FIG. 9]

(A)

(B)

(C)

[FIG. 10]

(A)

(B)

[FIG. 11]

[FIG. 12]

[FIG. 13]

[FIG. 14]

[FIG. 15]

[FIG. 16]

[FIG. 17]

Europäisches
Patentamt

European
Patent Office

Office européen
des brevets

# EUROPEAN SEARCH REPORT

Application Number

EP 21 17 4679

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | HIKARU NAKAJIMA ET AL: "C-14-11 One Dimensional Phase Measurement of Quasi-Millimeter Wave Using 2 Points Measurement Probe Based on Asynchronized Electro-optic Detection Technique", PROCEEDINGS OF THE 2016 ELECTRONICS SOCIETY CONFERENCE OF IEICE; SAPPORO; SEPTEMBER 20-23, 2016, JP, vol. 1, 6 September 2016 (2016-09-06), page 195, XP009527714, | 1,5 | INV. G01R1/07 G01R29/08 G01R29/10 |
| Y | * the whole document * | 2-4 | |
| A | | 6,7 | |
| Y | WO 2013/125502 A1 (STACK ELECTRONICS CO LTD [JP]; TOYO SEIKAN GROUP HOLDINGS LTD [JP]) 29 August 2013 (2013-08-29) | 2-4 | |
| A | * the whole document * | 1,5-7 | |
| A | US 2018/188305 A1 (HISATAKE SHINTAROU [JP] ET AL) 5 July 2018 (2018-07-05) * paragraph [0061] - paragraph [0133] * | 1-7 | |
| A | YAMAGUCHI KOKI ET AL: "Electric-field visualization technique for evaluating radiation from automotive millimeter-wave radar", 2017 IEEE MTT-S INTERNATIONAL CONFERENCE ON MICROWAVES FOR INTELLIGENT MOBILITY (ICMIM), IEEE, 19 March 2017 (2017-03-19), pages 151-154, XP033092005, DOI: 10.1109/ICMIM.2017.7918879 [retrieved on 2017-05-03] * the whole document * | 1-7 | G01R |

TECHNICAL FIELDS
SEARCHED (IPC)

The present search report has been drawn up for all claims

| Place of search | Date of completion of the search | Examiner |
|---|---|---|
| Munich | 15 October 2021 | Meggyesi, Zoltán |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 21 17 4679

This annex lists the patent family members relating to the patent documents cited in the above-mentioned European search report.
The members are as contained in the European Patent Office EDP file on
The European Patent Office is in no way liable for these particulars which are merely given for the purpose of information.

15-10-2021

| Patent document cited in search report | | Publication date | Patent family member(s) | | Publication date |
|---|---|---|---|---|---|
| WO 2013125502 | A1 | 29-08-2013 | JP | 2013200300 A | 03-10-2013 |
| | | | WO | 2013125502 A1 | 29-08-2013 |
| US 2018188305 | A1 | 05-07-2018 | CN | 107850635 A | 27-03-2018 |
| | | | EP | 3315979 A1 | 02-05-2018 |
| | | | JP | 6936560 B2 | 15-09-2021 |
| | | | JP | 2017015703 A | 19-01-2017 |
| | | | US | 2018188305 A1 | 05-07-2018 |
| | | | WO | 2017002782 A1 | 05-01-2017 |

EPO FORM P0459

For more details about this annex : see Official Journal of the European Patent Office, No. 12/82

**EP 3 913 378 A1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2001343410 A
- JP 2017015703 A